# EUROPEAN PATENT APPLICATION

(11) **EP 4 682 951 A1**
(43) Date of publication of application: **21.01.2026**
(21) Application number: 24770889.4
(22) Date of filing: 12.03.2024
(51) Int. Cl.: H01L 23/12

(54) **SEMICONDUCTOR PACKAGE AND PHASED ARRAY ANTENNA MODULE**

(30) Priority: 13.03.2023 JP 2023038519
(71) Applicant: Fujikura Ltd., Tokyo 135-8512 (JP)
(72) Inventor: TOMITA, Michikazu, Sakura-shi, Chiba 285-8550 (JP)
(74) Representative: Lavoix
(86) International application number: PCT/JP2024/009588
(87) International publication number: WO 2024/190784

(57) **Abstract**

A semiconductor package (1) includes an IC chip (10); a mold resin (20) surrounding the IC chip (10) in plan view; an insulating layer formed on one surface of the IC chip (10) and the mold resin (20); a plurality of solder bumps (50) formed on the insulating layer; and a rewiring (40) formed on the insulating layer and connecting the IC chip (10) to the plurality of solder bumps (50), in which the plurality of solder bumps (50) include an RF bump (51) through which a high-frequency signal passes, and a GND bump (52) electrically grounded, and the RF bump (51) is disposed at a position overlapping the mold resin (20) in plan view, and the GND bump (52) is disposed on a shortest line segment (L3, L4) connecting the RF bump (51) and the IC chip (10) in plan view.

## Description

### TECHNICAL FIELD

The present disclosure relates to a semiconductor package and a phased array antenna module.

Priority is claimed on Japanese Patent Application No. 2023-038519, filed March 13, 2023, the content of which is incorporated herein by reference.

### BACKGROUND ART

Patent Document 1 discloses a wafer level chip size package (WL-CSP) type semiconductor device in which a solder bump is directly formed on a semiconductor chip without interposing a substrate therebetween.

### Citation List

### Patent Document

Patent Document 1: Japanese Patent No. 5039384

### SUMMARY OF INVENTION

### Technical Problem

In a semiconductor package that handles a high-frequency signal, it is required to reduce the size thereof while satisfying high-frequency characteristics. Here, in order to reduce the size of the semiconductor package, when the pitch of the solder bumps is simply reduced, there is a possibility that a high-frequency signal will leak to another contact through an IC chip from the solder bump through which the high-frequency signal passes.

The present disclosure has been made in view of the above-described problems, and an object of the present disclosure is to improve isolation between a bump through which a high-frequency signal passes and an IC chip in a small-sized semiconductor package that handles a high-frequency signal.

### Solution to Problem

A semiconductor package according to a first aspect of the present disclosure includes an IC chip; a mold resin surrounding the IC chip in plan view; an insulating layer formed on one surface of the IC chip and the mold resin; a plurality of solder bumps formed on the insulating layer; and a rewiring formed on the insulating layer and connecting the IC chip to the plurality of solder bumps, in which the plurality of solder bumps include an RF bump through which a high-frequency signal passes, and a GND bump electrically grounded, and the RF bump is disposed at a position overlapping the mold resin in plan view, and the GND bump is disposed on a shortest line segment connecting the RF bump and the IC chip in plan view.

According to the first aspect of the present disclosure, in plan view of the semiconductor package, the GND bump disposed on the shortest line segment connecting the RF bump and the IC chip serves as a wall that limits leakage of a high-frequency signal during transmission of the high-frequency signal from the RF bump to the IC chip. Therefore, isolation between the RF bump through which the high-frequency signal passes and the IC chip can be improved.

A second aspect of the present disclosure is that in the semiconductor package according to the first aspect, a plurality of the RF bumps are provided around the IC chip in plan view, and the GND bump is disposed on a shortest line segment connecting the RF bump disposed to be closest to the IC chip in plan view among the plurality of RF bumps and the IC chip.

A third aspect of the present disclosure is that in the semiconductor package according to the first aspect or the second aspect, a plurality of the RF bumps are provided around the IC chip in plan view, and another GND bump included in the plurality of solder bumps and being different from the GND bump is disposed between the adjacent RF bumps.

A fourth aspect of the present disclosure is that in the semiconductor package according to any one of the first to third aspects, the RF bump is disposed at an outermost edge of the mold resin in plan view.

A fifth aspect of the present disclosure is that in the semiconductor package according to any one of the first to fourth aspects, on a straight line obtained by extending both ends of the shortest line segment connecting the RF bump and the IC chip, the straight line including the shortest line segment, the RF bump, the GND bump, the IC chip, another GND bump included in the plurality of solder bumps and being different from the GND bump, and another RF bump included in the plurality of solder bumps and being different from the RF bump are disposed in this order.

A sixth aspect of the present disclosure is that in the semiconductor package according to any one of the first to fifth aspects, the rewiring connected to the RF bump extends to a position overlapping the mold resin in plan view across a boundary between the IC chip and the mold resin, and is connected to the RF bump.

A seventh aspect of the present disclosure is that in the semiconductor package according to any one of the first to sixth aspects, the rewiring connected to the RF bump passes between the GND bump and another GND bump included in the plurality of solder bumps and being different from the GND bump at a position overlapping the mold resin in plan view, and is connected to the RF bump.

An eighth aspect of the present disclosure is that in the semiconductor package according to any one of the first to seventh aspects, the rewiring connected to the GND bump is disposed on both sides of the rewiring connected to the RF bump.

A ninth aspect of the present disclosure is that in the semiconductor package according to any one of the first to eighth aspects, the RF bump includes a first RF bump and a second RF bump having a relationship in which, when either one RF bump of the first and second RF bumps outputs a high-frequency signal, a high-frequency signal before being processed by the IC chip is input to the other RF bump thereof, and the GND bump is disposed on a shortest line segment connecting at least the first RF bump and the IC chip in plan view.

A phased array antenna module according to a tenth aspect of the present disclosure includes the semiconductor package according to any one of the first to ninth aspects, and a phased array antenna electrically connected to the semiconductor package. Advantageous Effects of Invention

According to the aspects of the present disclosure, in a small-sized semiconductor package that handles a high-frequency signal, isolation between a bump through which the high-frequency signal passes and an IC chip can be improved.

### BRIEF DESCRIPTION OF DRAWINGS

[FIG. 1] A block diagram of a phased array antenna device according to an embodiment.
[FIG. 2] A main part configuration diagram of the phased array antenna device according to the embodiment.
[FIG. 3] A plan view of a semiconductor package according to the embodiment.
[FIG. 4] A cross-sectional view taken along a line IV-IV and viewed in an arrow direction shown in FIG. 3.
[FIG. 5] An enlarged view of a region A shown in FIG. 3.

### DESCRIPTION OF EMBODIMENTS

Hereinafter, a semiconductor package and a phased array antenna module according to an embodiment of the present disclosure will be described with reference to the drawings.

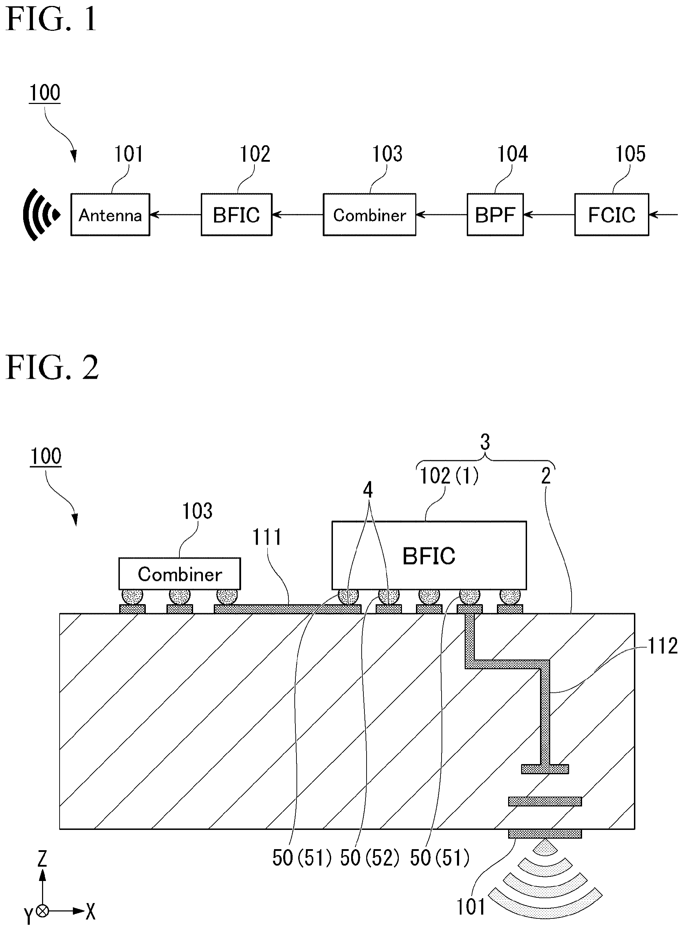

FIG. 1 is a block diagram of a phased array antenna device 100 according to the embodiment.

As shown in FIG. 1, the phased array antenna device 100 includes a phased array antenna 101, a beam forming IC (BFIC) 102, an antenna combiner 103, a band-pass filter (BPF) 104, and a frequency conversion IC (FCIC) 105.

The frequency conversion IC 105 converts the frequency of an intermediate frequency (IF) signal by using a local oscillator (LO) signal to generate a high-frequency signal (radio frequency (RF) signal), and outputs the high-frequency signal to the band-pass filter 104. The band-pass filter 104 attenuates a signal other than a predetermined frequency band, for example, attenuates the LO signal component, and outputs a high-frequency signal to the antenna combiner 103. The antenna combiner 103 distributes the high-frequency signal and outputs the high-frequency signal to each of a plurality of the beam forming ICs 102.

The beam forming IC 102 applies a phase difference to the high-frequency signal and outputs it to the phased array antenna 101. The phased array antenna 101 varies a beam direction according to the phase difference of the high-frequency signal. In FIG. 1, the flow of the signal during the transmission of the high-frequency signal is indicated by an arrow, but when the high-frequency signal is received, the flow of the signal is in an opposite direction to the arrow shown in FIG. 1.

FIG. 2 is a main part configuration diagram of the phased array antenna device 100 according to the embodiment.

The beam forming IC 102 is a semiconductor package 1 and is mounted on a substrate 2 as shown in FIG. 2. The semiconductor package 1 and the substrate 2 constitute a high-frequency module 3 (phased array antenna module). Hereinafter, the semiconductor package 1 of the beam forming IC 102 will be described, but the following configuration may be applied to the semiconductor package of the frequency conversion IC 105.

In addition, in the following description, the XYZ Cartesian coordinate system may be set, and the positional relationship of each member may be described with reference to the XYZ Cartesian coordinate system. As shown in FIG. 2, a Z-axis direction is set to a thickness direction of the semiconductor package 1 and the substrate 2 (that is, the high-frequency module 3). Hereinafter, the semiconductor package 1 side with respect to the substrate 2 will be referred to as an upper side or +Z side, and a side opposite to the semiconductor package 1 with respect to the substrate 2 will be referred to as a lower side or +Z side. The +Z side may not be the upper side in the gravity direction.

As shown in FIG. 2, a plurality of pads 4 are formed on an upper surface of the substrate 2. A plurality of solder bumps 50 electrically connected to the plurality of pads 4 are formed on a lower surface of the semiconductor package 1. The solder bump 50 includes RF bumps 51 through which a high-frequency signal passes, and GND bumps 52 that are electrically grounded.

In addition, the antenna combiner 103 is provided on the upper surface of the substrate 2. On the other hand, the phased array antenna 101 is provided on a lower surface of the substrate 2. The RF bump 51 of the semiconductor package 1 is electrically connected to a conductor 111 extending from the antenna combiner 103. In addition, another RF bump 51 of the semiconductor package 1 is electrically connected to a conductor 112 extending from the phased array antenna 101.

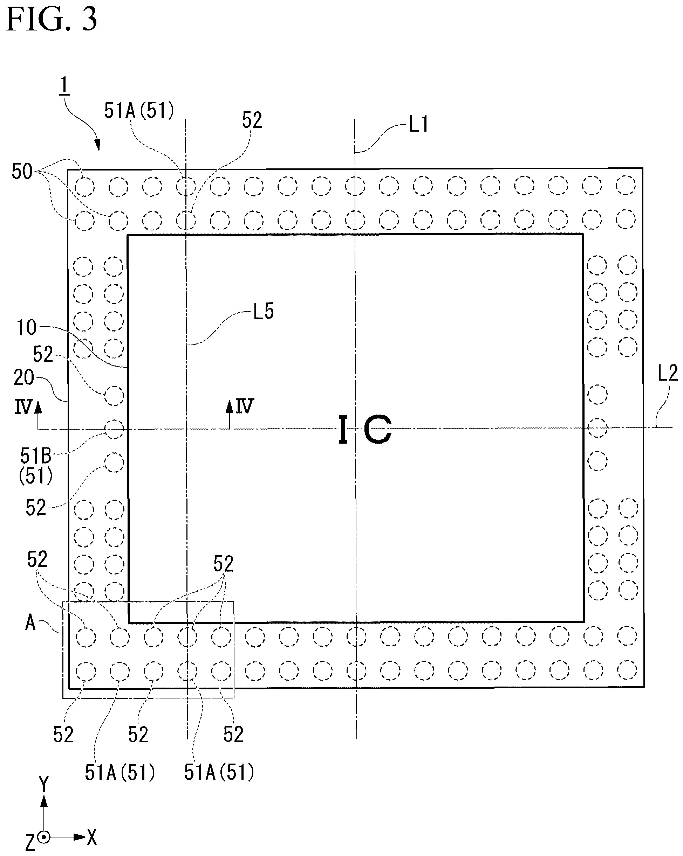

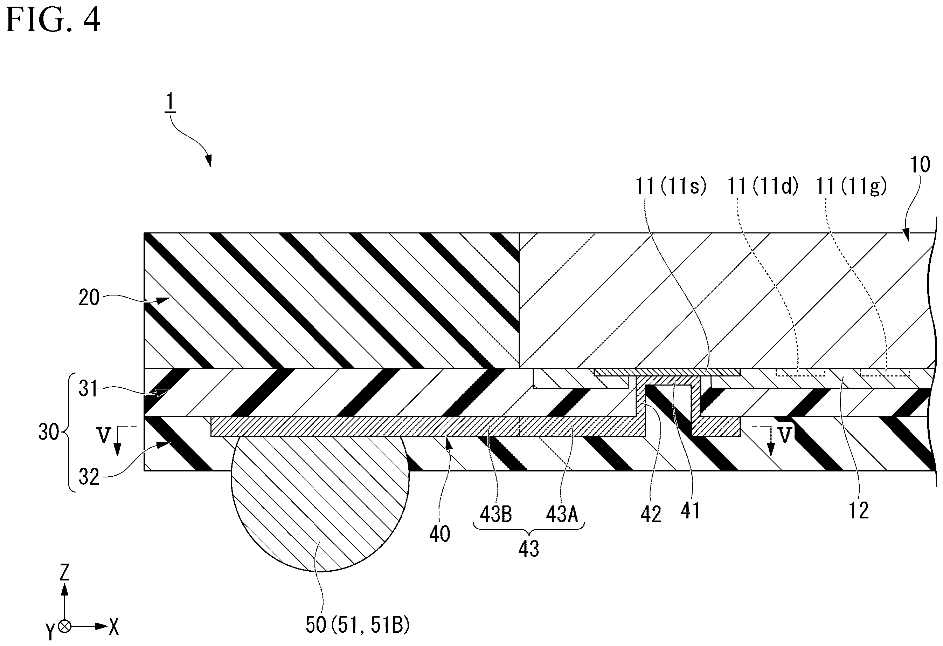

FIG. 3 is a plan view of the semiconductor package 1 according to the embodiment. FIG. 4 is a cross-sectional view taken along a line IV-IV and viewed in an arrow direction shown in FIG. 3.

As shown in FIGS. 3 and 4, the semiconductor package 1 includes an IC chip 10, a mold resin 20, an insulating layer 30, a plurality of rewirings 40, and the plurality of solder bumps 50. As shown in FIG. 4, the insulating layer 30 according to the present embodiment includes a first insulating layer 31 and a second insulating layer 32. The thickness of the semiconductor package 1 is 1 mm or less (for example, about 500 µm) excluding the solder bumps 50.

The "plan view" means a view of the semiconductor package 1 in the thickness direction (Z-axis direction). That is, FIG. 3 is a plan view of the semiconductor package 1. The "thickness direction" is also a direction in which the insulating layer 30 and the IC chip 10 of the semiconductor package 1 face each other. In addition, the "thickness direction" is also a direction in which the semiconductor package 1 and the substrate 2 of the high-frequency module 3 face each other.

As shown in FIG. 3, the outer shape of the semiconductor package 1 (the mold resin 20) is a rectangle in plan view. The term "rectangle" also includes a case where a shape can be regarded as a rectangle in a case where a manufacturing error is removed. In the semiconductor package 1, a first center line L1 and a second center line L2 orthogonal to each other in plan view can be defined. The semiconductor package 1 has two sides parallel to the first center line L1 and two sides parallel to the second center line L2.

The direction along the first center line L1 is a Y-axis direction, and the direction along the second center line L2 is an X-axis direction. The first center line L1 and the second center line L2 intersect each other at the center of the semiconductor package 1 in plan view.

The IC chip 10 includes a plurality of analog circuits (not shown, such as an inductor) and processes a high-frequency signal. The outer shape of the IC chip 10 is a rectangle in plan view. That is, the IC chip 10 has two sides parallel to the X-axis direction and two sides parallel to the Y-axis direction. In plan view, the center of the IC chip 10 and the center of the outer shape of the semiconductor package 1 (the outer shape of the mold resin 20) coincide with each other. The term "coincide" also includes a case in which the centers can be regarded as coinciding in a case where a manufacturing error is removed.

The mold resin 20 surrounds the IC chip 10 in plan view. As shown in FIG. 4, the IC chip 10 and the mold resin 20 are at the same position in the thickness direction. The IC chip 10 and the mold resin 20 are in contact with each other. As a specific material of the mold resin 20, for example, epoxy can be employed. In addition, the mold resin 20 may include a filler such as silica.

As a method for manufacturing the semiconductor package 1, a so-called fan out wafer level package (FOWLP) can be employed. As a specific example, a plurality of IC chips 10 may be disposed in a lattice shape, the gaps between the IC chips 10 may be filled with the mold resin 20, the rewirings 40 or the like may be formed, and then the mold resin 20 may be cut. According to such a manufacturing method, a plurality of semiconductor packages 1 can be efficiently manufactured at one time. As a method for manufacturing the semiconductor package 1, another method may be used, and, for example, a method of manufacturing each of a member on the IC chip 10 side and a member on the rewirings 40 side, bonding the members to each other, and then filling the mold resin 20 may be used. In addition, as the semiconductor package 1, a similar package, to the FOWLP, having the solder bumps 50 and the mold resin 20 and using, for example, a flip chip-ball grid array (FC-BGA) technology or a panel level package (PLP) technology may be employed.

As shown in FIG. 4, the mold resin 20 or the like may not be provided on an upper surface (+Z side end surface) of the IC chip 10, and the IC chip 10 may be exposed. As a result, the heat dissipation property of the IC chip 10 can be improved. Alternatively, a structure (a heat dissipation sheet, a heat dissipation fin, or the like) for improving the heat dissipation property may be provided on the upper surface of the IC chip 10.

A plurality of terminals 11 are provided on a lower surface (-Z side end surface) of the IC chip 10. Each of the terminals 11 is, for example, a pad made of aluminum. The plurality of terminals 11 include a high-frequency terminal 11s, a GND terminal 11g, a digital signal terminal 11d, and a power supply terminal (not shown).

The high-frequency terminal 11s is a terminal through which a high-frequency signal passes. The GND terminal 11g is a terminal that is electrically connected to a GND circuit (not shown) of the IC chip 10 and is set to a GND potential. The digital signal terminal 11d is a terminal that is electrically connected to a digital circuit (not shown) of the IC chip 10 and through which a digital signal flows. The power supply terminal is a terminal for supplying driving power to each portion of the IC chip 10.

The high-frequency terminal 11s is electrically connected to the solder bump 50 (the RF bump 51) through the rewiring 40. Although not shown, each of the other terminals 11 (the GND terminal 11g, the digital signal terminal 11d, the power supply terminal) is also electrically connected to other solder bumps 50 through the rewirings 40.

The solder bump 50 has a substantially spherical shape. The solder bump 50 is formed on the insulating layer 30. In addition, the solder bump 50 protrudes to the -Z side with respect to the insulating layer 30. As the material of the solder bump 50, SAC305, SAC405, or the like can be employed.

A passivation film 12 is provided on the lower surface of the IC chip 10. The passivation film 12 is, for example, a nitride film or an oxide film, and has a role of protecting the IC chip 10. However, in order to connect the terminal 11 and the rewiring 40 together, an opening is formed in a portion of the passivation film 12 overlapping the terminal 11.

The first insulating layer 31 is stacked on the -Z side of the IC chip 10 and the mold resin 20. The second insulating layer 32 is stacked on the -Z side of the first insulating layer 31. That is, the insulating layer 30 is formed on the lower surfaces of the IC chip 10 and the mold resin 20. In other words, the insulating layer 30 overlaps the IC chip 10 and the mold resin 20 in plan view.

As the materials of the first insulating layer 31 and the second insulating layer 32, for example, a transparent resin (for example, polyimide) can be suitably used. The insulating layer 30 may have a single-layer structure or a three-layer or more structure.

The rewiring 40 is formed on the insulating layer 30. As the material of the rewiring 40, for example, copper can be employed. The rewiring 40 has a terminal-bonding portion 41, a penetrating portion 42, and an extending portion 43. The terminal-bonding portion 41 is bonded to the terminal 11. The penetrating portion 42 extends from the terminal-bonding portion 41 to the -Z side and penetrates the first insulating layer 31 in the thickness direction.

The extending portion 43 extends in a direction (a direction along the X-Y plane) orthogonal to the thickness direction, and is formed to cross the boundary between the IC chip 10 and the mold resin 20 in plan view. Hereinafter, a portion of the extending portion 43 that overlaps the IC chip 10 in plan view may be referred to as a fan-in portion 43A, and a portion thereof that overlaps the mold resin 20 in plan view may be referred to as a fan-out portion 43B.

In the example of FIG. 4, the solder bump 50 is bonded to the fan-out portion 43B of the extending portion 43. As a result, for example, the RF bump 51 disposed at a position overlapping the mold resin 20 in plan view and the high-frequency terminal 11s disposed at a position overlapping the IC chip 10 in plan view can be connected to each other. It is desirable that the rewiring 40 is impedance-matched. The shape of the rewiring 40 can be appropriately changed. For example, the rewiring 40 connected to the solder bump 50 that overlaps the IC chip 10 in plan view may not include the fan-out portion 43B.

As shown in FIG. 3, the semiconductor package 1 includes the plurality of solder bumps 50 at positions overlapping the mold resin 20 in plan view. The plurality of solder bumps 50 are disposed line-symmetrically with respect to the first center line L1 in plan view, and are also disposed line-symmetrically with respect to the second center line L2 in plan view. The term "line symmetry" also includes a case where the line symmetry is achieved in a case where a manufacturing error is removed. The plurality of solder bumps 50 may not be disposed line-symmetrically with respect to at least one of the first center line L1 or the second center line L2 in plan view.

The plurality of solder bumps 50 include a first RF bump 51A and a second RF bump 51B as the RF bump 51 through which the high-frequency signal passes. The first RF bump 51A and the second RF bump 51B have a relationship in which, when either one RF bump 51 of the first RF bump 51A and the second RF bump 51B outputs a high-frequency signal, a high-frequency signal before being processed by the IC chip 10 is input to the other RF bump 51 thereof.

The first RF bump 51A is the RF bump 51 from or in which a high-frequency signal is output during transmission or a high-frequency signal is input during reception. The first RF bump 51A is electrically connected to the phased array antenna 101 described above (see FIG. 2). The phased array antenna 101 includes a plurality of antenna elements (for example, 4 × 4 antenna elements) disposed in an array shape. A plurality of first RF bumps 51A are provided to correspond to the plurality of antenna elements. The plurality of first RF bumps 51A and the GND bumps 52 are alternately provided along two sides of the outermost edge (outermost edge of the mold resin 20) of the semiconductor package 1, and the two sides extend to be parallel to the X-axis direction.

The second RF bump 51B is the RF bump 51 from or in which a high-frequency signal is output during reception or a high-frequency signal is input during transmission. The second RF bump 51B is electrically connected to the antenna combiner 103 described above (see FIG. 2). The second RF bump 51B is disposed on the second center line L2 of the semiconductor package 1. The second RF bump 51B is disposed on the IC chip 10 side, that is, the inner side, of the outermost edge of the semiconductor package 1. The second RF bump 51B may be disposed on the outermost edge side of the semiconductor package 1.

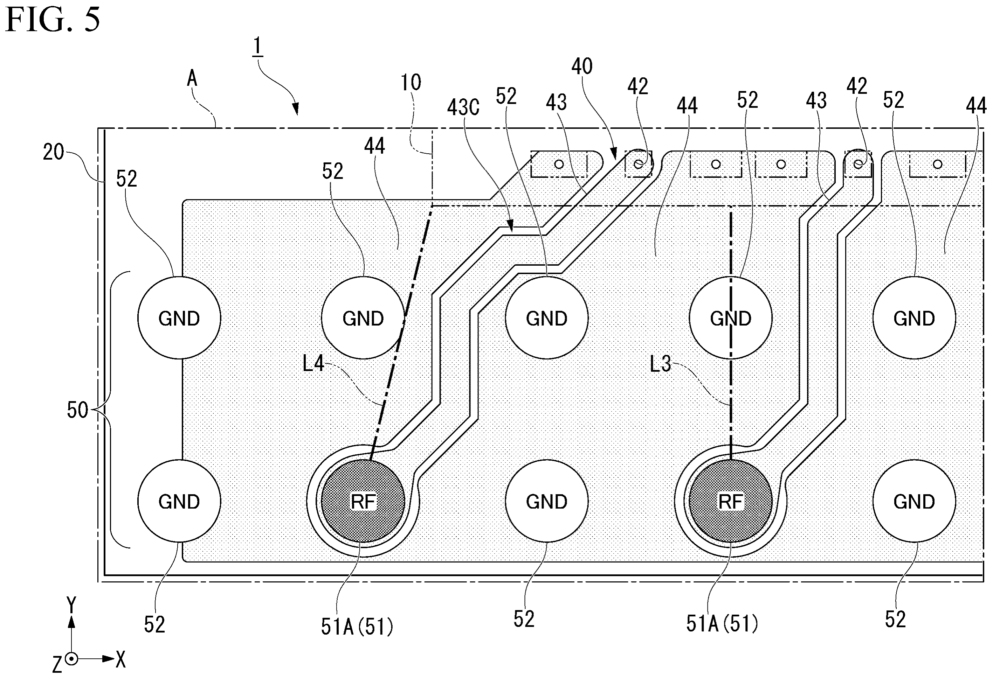

FIG. 5 is an enlarged view of a region A shown in FIG. 3. FIG. 5 is a view of the region A corresponding to a cross section V-V of FIG. 4. In the cross section V-V, the solder bumps 50 (the RF bump 51 and the GND bump 52) are disposed on the -Z side with respect to the rewiring 40, but in FIG. 5, for improvement of visibility, the solder bumps 50 (the RF bump 51 and the GND bump 52) disposed on the -Z side with respect to the rewiring 40 are represented in a transparent manner.

As shown in FIG. 5, the plurality of first RF bumps 51A are provided around the IC chip 10 in plan view. In addition, the first RF bump 51A is disposed at the outermost edge of the mold resin 20 in plan view. In the present embodiment, the "outermost edge" refers to a region closest to the outer peripheral edge of the semiconductor package 1 (that is, the mold resin 20) in plan view, in a region in which the solder bumps 50 can be disposed in the semiconductor package 1. That is, no GND bump 52 is disposed outside the first RF bump 51A. The GND bumps 52 are disposed to surround each of the first RF bumps 51A in plan view.

The GND bump 52 is disposed on each of shortest line segments L3 and L4 connecting the first RF bump 51A and the IC chip 10 in plan view. The center of the GND bump 52 disposed on the shortest line segment L3 is positioned on the shortest line segment L3. In addition, a portion (edge portion) of the GND bump 52 disposed on the shortest line segment L4 is positioned on the shortest line segment L3. The "line segment" in the present embodiment is a line of which both ends are limited, and is distinguished from a "straight line" that has no both ends and extends without limit.

Among the two first RF bumps 51A shown in FIG. 5, the first RF bump 51A disposed on the +X side faces a side of the outer shape of the IC chip 10, which extends in the X-axis direction, in the Y-axis direction in plan view. This first RF bump 51A corresponds to the first RF bump 51A disposed to be closest to the IC chip 10 in plan view. In the present embodiment, there are a plurality of "first RF bumps 51A disposed to be closest to the IC chip 10 in plan view" at an equidistant from the IC chip 10, instead of one. The term "equidistant" also includes a case where the distance can be regarded as the equidistance in a case where a manufacturing error is removed.

Among the two first RF bumps 51A shown in FIG. 5, the first RF bump 51A disposed on the -X side does not face a side of the outer shape of the IC chip 10, which extends in the X-axis direction, in the Y-axis direction in plan view. This first RF bump 51A is disposed on the -X side of the IC chip 10 in plan view, and the shortest line segment L4 extending from the first RF bump 51A is connected to a corner portion of the outer shape of the IC chip 10. The shortest line segment L4 is greater than the shortest line segment L3. That is, in FIG. 5, the first RF bump 51A disposed on the -X side does not correspond to the "first RF bump 51A disposed to be closest to the IC chip 10 in plan view".

The GND bump 52 may be disposed on the shortest line segment L3 connecting at least the first RF bump 51A disposed to be closest to the IC chip 10 in plan view and the IC chip 10. That is, the GND bump 52 does not have to be disposed on the shortest line segment L4. This is because the first RF bump 51A disposed to be closest to the IC chip 10 in plan view is more affected by the leakage of the high-frequency signal through the IC chip 10 than the first RF bump 51A disposed away from the IC chip 10.

As described above, the plurality of solder bumps 50 are disposed line-symmetrically with respect to the second center line L2 in plan view shown in FIG. 3. Therefore, the first RF bump 51A, the GND bump 52, the IC chip 10, another GND bump 52, and another first RF bump 51A are disposed in this order on a straight line L5 obtained by extending both ends of the shortest line segment L3, and the straight line L5 includes the shortest line segment L3.

Returning to FIG. 5, the rewiring 40 (the extending portion 43) connected to the first RF bump 51A passes between the GND bumps 52 at a position overlapping the mold resin 20 in plan view and is connected to the first RF bump 51A. Specifically, in FIG. 5, the rewiring 40 (the extending portion 43) connected to the first RF bump 51A disposed on the +X side extends in an oblique 45-degree direction from the penetrating portion 42 and then passes between the GND bumps 52 adjacent to each other in the X-axis direction. One of these GND bumps 52 adjacent to each other in the X-axis direction is disposed on the shortest line segment L3.

In addition, in FIG. 5, the rewiring 40 (the extending portion 43) connected to the first RF bump 51A disposed on the -X side extends in an oblique 45-degree direction from the penetrating portion 42, and then bypasses the GND bump 52 positioned on the extension line thereof to pass between the GND bumps 52 adjacent to each other in the X-axis direction. That is, the rewiring 40 (the extending portion 43) connected to the first RF bump 51A disposed on the -X side includes a bypass portion 43C that bypasses the GND bump 52 in a substantially C shape. One of these GND bumps 52 adjacent to each other in the X-axis direction is disposed on the shortest line segment L4. It is desirable that the distance between the GND bumps 52 adjacent to each other in the X-axis direction is about 300 µm to 500 µm.

The GND bump 52 is further disposed between the first RF bumps 51A adjacent to each other in the X-axis direction. As a result, isolation between the first RF bumps 51A adjacent to each other can be improved. In addition, a solid pattern 44 of the rewiring 40 connected to the GND bump 52 is disposed on both sides of the rewiring 40 connected to the first RF bump 51A. As a result, the isolation between the first RF bumps 51A adjacent to each other can be further improved.

As described above, in the present embodiment, the GND bump 52 disposed on the shortest line segments L3 and L4 connecting the RF bump 51 and the IC chip 10 in plan view of the semiconductor package 1 plays a role of a wall that limits the leakage of a high-frequency signal generated during the transmission of the high-frequency signal from the RF bump 51 to the IC chip 10. Therefore, isolation between the RF bump 51 through which the high-frequency signal passes and the IC chip 10 can be improved.

The isolation between the rewiring 40, the RF bump 51, and the IC chip 10 in the semiconductor package 1 can be confirmed in advance by simulation or the like, but it takes a lot of time and effort. Therefore, as in the present embodiment, by appropriately disposing the GND bump 52 and taking measures against the leakage of the high-frequency signal, simulation is not required, and the wasteful time and effort can be reduced.

As described above, the semiconductor package 1 according to the present embodiment includes the IC chip 10, the mold resin 20 that surrounds the IC chip 10 in plan view, the insulating layer 30 that is formed on one surface of the IC chip 10 and the mold resin 20, the plurality of solder bumps 50 that are formed on the insulating layer 30, and the rewiring 40 that is formed on the insulating layer 30 and connects the IC chip 10 to the plurality of solder bumps 50, in which the plurality of solder bumps 50 include the RF bump 51 through which a high-frequency signal passes and the GND bump 52 that is electrically grounded, the RF bump 51 is disposed at a position overlapping the mold resin 20 in plan view, and the GND bump 52 is disposed on the shortest line segment L3 or L4 that connect the RF bump 51 and the IC chip 10 together in plan view. According to this configuration, in the small-sized semiconductor package 1 that handles the high-frequency signal, isolation between the RF bump 51 through which the high-frequency signal passes and the IC chip 10 can be improved.

In addition, in the present embodiment, the RF bump 51 includes the first RF bump 51A and the second RF bump 51B that have a relationship in which, when one RF bump 51 of the first RF bump 51A and the second RF bump 51B outputs the high-frequency signal, the high-frequency signal before being processed by the IC chip 10 is input to the other RF bump 51 thereof, and the GND bump 52 is disposed on the shortest line segment L3 or L4 connecting at least the first RF bump 51A and the IC chip 10 in plan view. According to this configuration, it is possible to limit the high-frequency signal from leaking from the first RF bump 51A through which the high-frequency signal passes to another contact (the second RF bump 51B) through the IC chip.

In the present embodiment, no GND bump 52 is disposed on a shortest line segment connecting the second RF bump 51B and the IC chip 10 in plan view shown in FIG. 3, but the GND bump 52 may be disposed therein similarly to the first RF bump 51A. In addition, by not disposing the GND bump 52, the semiconductor package 1 can be downsized.

In addition, in the present embodiment, the plurality of first RF bumps 51A are provided around the IC chip 10 in plan view, and the GND bump 52 is disposed on the shortest line segment L3 connecting the first RF bump 51A disposed to be closest to the IC chip 10 in plan view among the plurality of first RF bumps 51A and the IC chip 10. According to this configuration, it is possible to limit the leakage of the high-frequency signal from the first RF bump 51A disposed to be closest to the IC chip 10 in plan view.

In addition, in the present embodiment, the plurality of first RF bumps 51A are provided around the IC chip 10 in plan view, and the GND bump 52 is further disposed between the adjacent first RF bumps 51A. According to this configuration, isolation between the adjacent first RF bumps 51A can be improved.

In addition, in the present embodiment, the first RF bump 51A is disposed at the outermost edge of the mold resin 20 in plan view. According to this configuration, since the GND bump 52 is not disposed outside the first RF bump 51A, the semiconductor package 1 can be downsized.

In addition, in the present embodiment, on the straight line L5 obtained by extending both ends of the shortest line segment L3 connecting the first RF bump 51A and the IC chip 10, in which the straight line L5 includes the shortest line segment L3, the first RF bump 51A, the GND bump 52, the IC chip 10, the other GND bump 52, and the other first RF bump 51A are disposed in this order. According to this configuration, isolation between the first RF bump 51A and the IC chip 10 can be improved in the opposite side with the IC chip 10 interposed therebetween in the same manner.

In addition, in the present embodiment, the rewiring 40 connected to the first RF bump 51A extends to a position overlapping the mold resin 20 in plan view across a boundary between the IC chip 10 and the mold resin 20 and is connected to the first RF bump 51A. According to this configuration, since the rewiring 40 connected to the first RF bump 51A extends in a direction away from the IC chip 10, isolation between the rewiring 40 and the IC chip 10 can be improved.

In addition, in the present embodiment, the rewiring 40 connected to the RF bump 51 passes between the GND bumps 52 at a position overlapping the mold resin 20 in plan view and is connected to the RF bump 51. According to this configuration, since the rewiring 40 connected to the first RF bump 51A extends in a direction away from the IC chip 10 and the GND bumps 52 are disposed on both sides of the rewiring 40, isolation between the rewiring 40 and the IC chip 10 can be further improved.

In addition, in the present embodiment, the rewiring 40 (the solid pattern 44) connected to the GND bump 52 is disposed on both sides of the rewiring 40 connected to the RF bump 51. According to this configuration, since the solid pattern 44 to which the GND bump 52 is connected is disposed on both sides of the rewiring 40, isolation between the rewiring 40 and the IC chip 10 can be further improved.

In addition, the phased array antenna device 100 according to the present embodiment includes the semiconductor package 1 and the phased array antenna 101 electrically connected to the semiconductor package 1. According to this configuration, the high-frequency module 3 (phased array antenna module) that is small-sized and has high-performance is obtained.

Although appropriate embodiments of the present disclosure have been described and shown, it should be understood that these embodiments are exemplary of the present disclosure and are not considered as limiting the present disclosure. Additions, omissions, substitutions, and other modifications can be made within the scope of the present disclosure. Accordingly, the present disclosure should not be considered as being limited by the foregoing descriptions, and is only limited by the scope of the appended claims.

For example, the outer shape of the mold resin 20 may be a square in plan view. Similarly, the outer shape of the IC chip 10 may be a square in plan view. That is, each of the outer shapes of the IC chip 10 and the mold resin 20 may be a rectangle. In the present specification, the term "square" also includes a case where a shape can be regarded as a square in a case where a manufacturing error is removed.

In addition, for example, the center of the mold resin 20 and the center of the IC chip 10 may not coincide with each other in plan view.

In addition, for example, an underfill may be applied between the semiconductor package 1 and the substrate 2. The underfill may contain a filler such as epoxy or silica. In this case, the mechanical strength of the connection between the IC chip 10 and the mold resin 20 can be increased.

In addition, it is possible to appropriately replace the components in the above-described embodiments with known components within the scope of the present disclosure, and the above-described embodiments and modification examples may be combined as appropriate.

### REFERENCE SIGNS LIST

1 Semiconductor package
2 Substrate
3 High-frequency module (phased array antenna module)
4 Pad
10 IC chip
11 Terminal
11d Digital signal terminal
11g GND terminal
11s High-frequency terminal
12 Passivation film
20 Mold resin
30 Insulating layer
31 First insulating layer
32 Second insulating layer
40 Rewiring
41 Terminal-bonding portion
42 Penetrating portion
43 Extending portion
43A Fan-in portion
43B Fan-out portion
43C Bypass portion
44 Solid pattern
50 Solder bump
51 RF bump
51A First RF bump
51B Second RF bump
52 GND bump
100 Phased array antenna device
101 Phased array antenna
102 Beam forming IC
103 Antenna combiner
104 Band-pass filter
105 Frequency conversion IC
111 Conductor
112 Conductor
L1 First center line
L2 Second center line
L3 Shortest line segment
L4 Shortest line segment

## Claims

1. A semiconductor package comprising:
an IC chip;
a mold resin surrounding the IC chip in plan view;
an insulating layer formed on one surface of the IC chip and the mold resin;
a plurality of solder bumps formed on the insulating layer; and
a rewiring formed on the insulating layer and connecting the IC chip to the plurality of solder bumps, wherein
the plurality of solder bumps include
an RF bump through which a high-frequency signal passes, and
a GND bump electrically grounded, and
the RF bump is disposed at a position overlapping the mold resin in plan view, and the GND bump is disposed on a shortest line segment connecting the RF bump and the IC chip in plan view.

2. The semiconductor package according to claim 1, wherein
a plurality of the RF bumps are provided around the IC chip in plan view, and
the GND bump is disposed on a shortest line segment connecting the RF bump disposed to be closest to the IC chip in plan view among the plurality of RF bumps and the IC chip.

3. The semiconductor package according to claim 1 or 2, wherein
a plurality of the RF bumps are provided around the IC chip in plan view, and
another GND bump included in the plurality of solder bumps and being different from the GND bump is disposed between the adjacent RF bumps.

4. The semiconductor package according to any one of claims 1 to 3, wherein
the RF bump is disposed at an outermost edge of the mold resin in plan view.

5. The semiconductor package according to any one of claims 1 to 4, wherein
on a straight line obtained by extending both ends of the shortest line segment connecting the RF bump and the IC chip, the straight line including the shortest line segment,
the RF bump, the GND bump, the IC chip, another GND bump included in the plurality of solder bumps and being different from the GND bump, and another RF bump included in the plurality of solder bumps and being different from the RF bump are disposed in this order.

6. The semiconductor package according to any one of claims 1 to 5, wherein
the rewiring connected to the RF bump extends to a position overlapping the mold resin in plan view across a boundary between the IC chip and the mold resin, and is connected to the RF bump.

7. The semiconductor package according to any one of claims 1 to 6, wherein
the rewiring connected to the RF bump passes between the GND bump and another GND bump included in the plurality of solder bumps and being different from the GND bump at a position overlapping the mold resin in plan view, and is connected to the RF bump.

8. The semiconductor package according to any one of claims 1 to 7, wherein
the rewiring connected to the GND bump is disposed on both sides of the rewiring connected to the RF bump.

9. The semiconductor package according to any one of claims 1 to 8, wherein
the RF bump includes a first RF bump and a second RF bump having a relationship in which, when either one RF bump of the first and second RF bumps outputs a high-frequency signal, a high-frequency signal before being processed by the IC chip is input to the other RF bump thereof, and
the GND bump is disposed on a shortest line segment connecting at least the first RF bump and the IC chip in plan view.

10. A phased array antenna module comprising:
the semiconductor package according to any one of claims 1 to 9; and
a phased array antenna electrically connected to the semiconductor package.
